# DEMANDE DE BREVET EUROPEEN

(11) **EP 4 391 077 A1**
(43) Date de publication de la demande: **26.06.2024**
(21) Numéro de dépôt: 23218371.5
(22) Date de dépôt: 19.12.2023
(51) Int. Cl.: H01L 29/66, H01L 29/45

(54) **REALISATION D'UN TRANSISTOR A SOURCE ET DE DRAIN SILICIUREES PROCHES DU CANAL**

(30) Priorité: 20.12.2022 FR 2213954
(71) Demandeur: Commissariat à l'énergie atomique et aux énergies alternatives, 75015 Paris (FR)
(72) Inventeur: REBOH, Shay, 38054 GRENOBLE CEDEX 09 (FR); ACOSTA ALBA, Pablo, 38054 GRENOBLE CEDEX 09 (FR); MILESI, Frédéric, 38054 GRENOBLE CEDEX 09 (FR); BRUNET, Laurent, 38054 GRENOBLE CEDEX 09 (FR)
(74) Mandataire: Brevalex

(57) **Abrégé**

Procédé pour la réalisation de source et drain de transistor en alliage de métal et semi-conducteur comprenant, dans cet ordre, les étapes suivantes :
- prévoir sur un support (100) doté d'une couche isolante (11) et d'une couche semi-conductrice superficielle (12) reposant sur la couche isolante (11) : un bloc (25) de grille de transistor sur cette couche semi-conductrice superficielle (12) et des espaceurs isolants (33) de part et d'autre dudit bloc (25) de grille,
- rendre amorphe des régions semi-conductrices (123) de ladite couche semi-conductrice superficielle (12) situées de part et d'autre du bloc (25) de grille, tout en conservant au moins une zone semi-conductrice cristalline (121) de la couche semi-conductrice superficielle (12) en regard du bloc (25) de grille,
- former de manière sélective par rapport à ladite zone (121) cristalline de la couche semi-conductrice superficielle, des régions d'alliage de métal et de semi-conducteur (125) dans les régions semi-conductrices rendues amorphes de la couche semi-conductrice superficielle (12).

## Description

### DOMAINE TECHNIQUE ET ÉTAT DE LA TECHNIQUE ANTÉRIEURE

La présente demande concerne le domaine des procédés de fabrication de transistors, et plus particulièrement celui de la formation de régions en alliage de métal et semi-conducteur en particulier pour les zones de source et le drain de transistor(s).

Dans les procédés de fabrication de transistors on réalise couramment des zones dites « siliciurées » composées de silicium et d'un ou plusieurs éléments métalliques. Les zones siliciurées sont notamment utilisées pour former des zones de contact pour la source et le drain de transistors et permettent d'améliorer les contacts entre des plots métalliques et des régions de source et de drain semi-conductrices.

Le document "Characterization of fully silicided source/drain SOI UTBB nMOSFETs at cryogenic températures", de Yi Han et al. prévoit la mise en oeuvre d'un dispositif microélectronique pour lequel on effectue une siliciuration complète de régions d'une couche semi-conductrice superficielle d'un substrat de type SOI (« Silicon On Insulator » ou « silicium sur isolant ») situées de part et d'autre d'une électrode de grille.

Un inconvénient du procédé décrit est que la jonction ou l'interface siliciure/semi-conducteur n'est pas définie précisément.

### EXPOSÉ DE L'INVENTION

Un but de l'invention est de proposer un procédé amélioré de réalisation d'un dispositif microélectronique à transistor(s) doté(s) de régions de source et de drain en alliage de métal et de semi-conducteur réalisées dans une même couche semi-conductrice superficielle que celle dans laquelle la région de canal de ce ou ces transistors est prévue.

Il s'agit en particulier d'obtenir un positionnement plus précis et un meilleur contrôle des interfaces entre d'une part les régions alliage de métal et de semi-conducteur formées pour la source et le drain et d'autre par la zone semi-conductrice cristalline dans laquelle on prévoit la région de canal.

Ainsi, selon un aspect, un mode de réalisation prévoit un procédé comprenant, dans cet ordre, les étapes suivantes :
- prévoir sur un support doté d'une couche isolante et d'une couche semi-conductrice superficielle reposant sur la couche isolante : un bloc de grille de transistor sur cette couche semi-conductrice superficielle,
- rendre amorphe des régions semi-conductrices de ladite couche semi-conductrice superficielle situées de part et d'autre du bloc de grille, tout en conservant au moins une zone semi-conductrice cristalline de la couche semi-conductrice superficielle en regard du bloc de grille,
- former des régions d'alliage de métal et de semi-conducteur dans les régions semi-conductrices rendues amorphes de la couche semi-conductrice superficielle.

Les inventeurs ont découvert que des régions d'alliage de métal et de semi-conducteur se formaient sélectivement dans des régions semi-conductrices rendues amorphes d'une structure semi-conductrice comportant des régions amorphes et des régions cristallines.

Cette sélectivité permet, en définissant préalablement des régions amorphes d'obtenir des régions d'alliage de métal et de semi-conducteur positionnées au plus près du canal tout en ayant une interface définie et positionnée de manière précise entre ces régions et la zone semi-conductrice cristalline dans laquelle le canal est prévu.

On forme ici ces régions d'alliage de métal et de semi-conducteur au plus près du canal, dans la couche superficielle dans laquelle ce dernier est prévu, ce qui peut permettre avantageusement d'éviter de réaliser des zones de source et de drain surélevées par croissance épitaxiale. On limite dans ce cas le coût du procédé et le budget thermique nécessaire pour le mettre en oeuvre.

Avantageusement, préalablement à l'étape consistant à rendre amorphe ou concomitamment à l'étape consistant à rendre amorphe lesdites régions semi-conductrices : le procédé peut comprendre un dopage de portions de la couche semi-conductrice superficielle de part et d'autre de ladite zone cristalline.

Un tel dopage est réalisé typiquement par implantation.

Avantageusement, l'amorphisation des régions semi-conductrices est effectuée par implantation dopante de sorte à doper concomitamment les régions semi-conductrices de la couche semi-conductrice superficielle.

Selon une possibilité de mise en oeuvre, préalablement à l'amorphisation des régions semi-conductrices une implantation dopante de sorte à doper des zones dites d'extension de la couche semi-conductrice superficielle est effectuée, les espaceurs isolants étant agencés en regard desdites zones d'extension.

Selon une possibilité de mise en oeuvre, un dopage des zones d'extension peut être effectué par implantation à l'aide d'un faisceau parallèle à une normale à un plan principal du support et préalablement à une étape consistant à former des espaceurs isolants de part et d'autre du bloc de grille, l'amorphisation des régions semi-conductrices étant réalisée après formation des espaceurs isolants.

En variante, un dopage desdites zones d'extension peut être effectué après formation desdits espaceurs isolants de part et d'autre dudit bloc de grille, par implantation à faisceau incliné par rapport à une normale à un plan principal du support.

Le procédé peut comprendre en outre, après dopage desdites portions de la couche semi-conductrice superficielle et l'étape consistant à rendre amorphe lesdites régions semi-conductrices au moins un recuit d'activation de dopants prévu de sorte à ne pas recristalliser, en particulier ne pas rendre polycristallines ou monocristallines, lesdites régions semi-conductrices rendues amorphes.

On évite ainsi de devoir nécessairement réaliser à nouveau une amorphisation afin de pouvoir réaliser ensuite la formation sélective des régions d'alliage de métal et de semi-conducteur dans les régions amorphes.

Selon une autre possibilité de mise en oeuvre, le procédé peut comprendre en outre, après dopage desdites portions de la couche semi-conductrice superficielle et l'étape consistant à former lesdites régions d'alliage de métal et de semi-conducteur, au moins un recuit d'activation de dopants. Dans ce cas de figure, on diffère avantageusement le recuit d'activation de dopants afin de ne pas risquer de recristalliser les régions rendues amorphes.

Selon un mode de réalisation particulier l'étape consistant à rendre amorphe lesdites régions semi-conductrices peut comprendre une implantation à faisceau incliné par rapport à une normale à un plan principal du support. Cela peut permettre de réaliser les régions d'alliage de métal et de semi-conducteur dans une zone très proche du canal.

Avantageusement, le support est doté d'un ou plusieurs composants d'un premier niveau de composants formés dans une couche semi-conductrice sous-jacente. Ainsi, le procédé se prête tout particulièrement à la réalisation de dispositifs ou circuits 3D dotés de plusieurs couches semi-conductrices superposées et plusieurs niveaux de composants réalisés dans ces couches.

En particulier, le fait de pouvoir éviter de réaliser une ou plusieurs étapes d'épitaxie pour former des régions de source et de drain surélevées permet de prévoir un budget thermique davantage compatible à la mise en oeuvre de circuits ou dispositifs 3D.

Selon un mode de réalisation particulier, on peut réaliser un ou plusieurs plots de contact directement sur des régions d'alliage de métal et de semi-conducteur formées dans la couche superficielle. Ainsi, selon un mode de réalisation le procédé peut comprendre en outre des étapes consistant à :
- former au moins une couche isolante sur les régions d'alliage de métal et de semi-conducteur et la grille,
- réaliser au moins une ouverture dévoilant au moins une région donnée parmi lesdites régions d'alliage de métal et de semi-conducteur,
- formation d'un plot conducteur en contact avec ladite région donnée.

Avantageusement, avec la formation des régions d'alliage de métal et de semi-conducteur formées dans la couche superficielle, on peut éviter d'avoir à réaliser une étape d'épitaxie de régions surélevées de source et de drain avant de réaliser le plot conducteur.

### BRÈVE DESCRIPTION DES DESSINS

La présente invention sera mieux comprise sur la base de la description qui va suivre et des dessins en annexe sur lesquels :
Les figure 1A et B illustrent un procédé de réalisation sélective de régions d'alliage de métal et de semi-conducteur dans des régions amorphes formées dans la couche superficielle d'un substrat de type semi-conducteur sur isolant.
La figure 2 illustre un exemple de réalisation particulier pour lequel les régions amorphes sont réalisées par implantation de part et d'autre d'espaceurs isolants prévus contre un bloc de grille.
Les figure 3A et 3B illustrent un autre exemple de réalisation particulier pour lequel les régions amorphes sont réalisées par implantation à l'aide d'un faisceau incliné.
La figure 4 illustre un exemple de réalisation particulier dans lequel le support sur lequel on réalise l'amorphisation et la siliciuration sélective de régions amorphisées d'une couche semi-conductrice superficielle est déjà doté d'un niveau de composants formés dans une autre couche semi-conductrice sous-jacente.
La figure 5 illustre un exemple de réalisation particulier dans lequel on effectue en outre un dopage de zones d'accès sous les espaceurs.
La figure 6 illustre un autre exemple de réalisation dans lequel l'amorphisation est réalisée après dopage de zones d'accès et formation d'espaceurs de part et d'autre du bloc de grille.
Les figure 7A et 7B illustrent un exemple de réalisation dans lequel l'activation de dopants est réalisée après formation de régions d'alliage de métal et de semi-conducteur.
La figure 8 illustre une activation de dopants implanté dans des régions semi-conductrice amorphe, l'activation étant effectuée sans recristallisation de ces régions.
Les Figure 9A à 9E illustrent la réalisation de plots de contact directement sur les régions d'alliage de métal et de semi-conducteur formées dans la même couche semi-conductrice superficielle que celle dans laquelle la région de de canal de transistors est formée.

En outre, dans la description ci-après, des termes qui dépendent de l'orientation d'une structure tels que « avant », « supérieure », « arrière », « inférieure », « latérale », s'appliquent en considérant que la structure est orientée de la façon illustrée sur les figures.

### EXPOSÉ DÉTAILLÉ DE MODES DE RÉALISATION PARTICULIERS

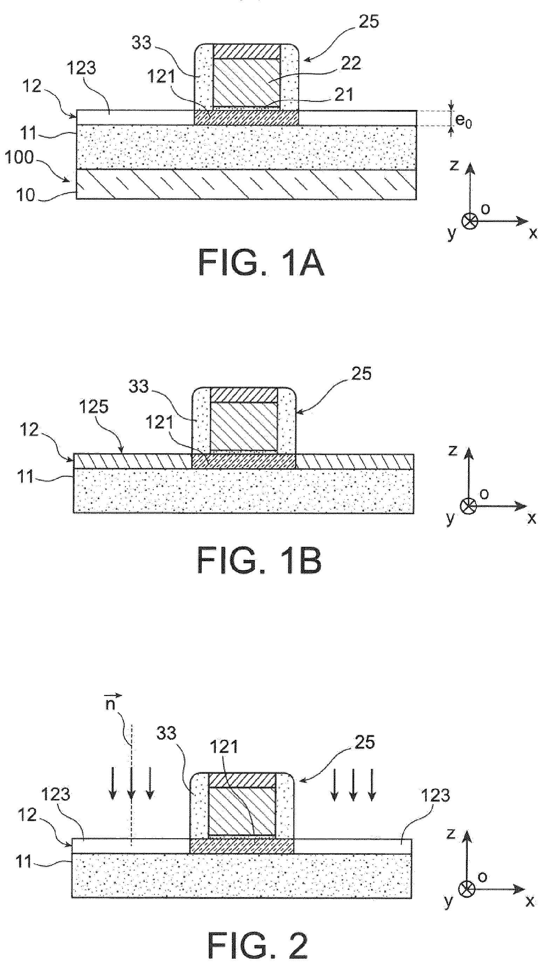

Une structure de départ possible pour la mise en oeuvre de régions de source et de drain de transistor à base d'alliage de métal et de semi-conducteur est donnée sur la figure 1A.

Cette structure comprend un support 100 doté d'une couche isolante 11, par exemple en SiOz, et communément appelée de BOX (« buried-oxide » ou oxyde enterré), la couche isolante 11 étant elle-même revêtue d'une couche semi-conductrice 12 superficielle dans laquelle un ou plusieurs transistors sont destinés à être formés.

La couche semi-conductrice 12 superficielle, par exemple en silicium, est prévue avec une épaisseur qui peut être comprise par exemple entre 5 nm et 100 nm, avantageusement entre 5 et 20 nm.

Le support 100 sur lequel repose la couche isolante 11 peut être par exemple une couche semi-conductrice, la structure étant dans ce cas réalisée à partir d'un substrat de type semi-conducteur sur isolant, par exemple de type SOI (SOI pour « Silicon On Insulator » ou « Silicium sur isolant »). Le ou les transistors formés peuvent être alors prévus en technologie FDSOI (pour "Fully Depleted Silicon On Insulator" ou « silicium sur isolant totalement déplété »).

Dans l'exemple de réalisation illustré, la structure est dotée également d'un bloc 25 de grille. Ce bloc 25 est formé ici d'une région 21 de diélectrique de grille, par exemple en SiOz ou en HfOz surmontée d'une région 22 de grille formé d'une ou plusieurs couches de matériau de grille par exemple à base de polysilicium ou de TiN ou de W ou d'un empilement d'au moins plusieurs de ces matériaux. Des espaceurs 33 sont formés de part et d'autre du bloc 25 de grille. Ces espaceurs 33 peuvent être par exemple à base de SiN ou de SiBCN ou de SiOCN.

La couche semi-conductrice superficielle 12 est ici pourvue de régions 123 en matériau semi-conducteur amorphe, par exemple en silicium amorphe tandis qu'une zone 121 en matériau semi-conducteur cristallin, par exemple silicium cristallin, est préservée en regard du bloc 25 de grille. Dans cet exemple, cette zone de matériau semi-conducteur cristallin s'étend en regard d'au moins une partie des espaceurs isolants 33. Une zone cristalline de la couche semi-conductrice 12 dans laquelle le canal du transistor et au moins une partie des zones d'extensions est ici ainsi préservée.

Les régions amorphes 123 peuvent s'étendre comme sur la figure 1A sur toute l'épaisseur e₀ de la couche semi-conductrice 12.

On réalise ensuite (figure 1B) des régions 125 d'alliage de métal et de semi-conducteur dans les régions semi-conductrices amorphes 123 de part et d'autre de la zone semi-conductrice 121. Les régions 125 sont en particulier des zones à base de siliciure lorsque la couche semi-conductrice superficielle 12 est en silicium. On réalise les régions 125 d'alliage de métal et de semi-conducteur, de préférence à une température inférieure à 600°C et avantageusement inférieure à 500°C. Pour cela, on peut utiliser par exemple un procédé de pulvérisation (« sputtering » selon la terminologie anglo-saxonne) pour déposer un matériau métallique. Un tel procédé utilise une ou plusieurs cibles dont est ou sont extrait(s) l'élément ou les éléments à déposer. Un exemple particulier de procédé consiste à réaliser une siliciuration. La siliciuration comprend un dépôt métallique que l'on vient chauffer pour qu'il réagisse avec la couche semi-conductrice pour former un siliciure. Un retrait de métal sélectivement par rapport à l'alliage créé peut être ensuite effectué. On peut former par exemple par siliciuration des zones de NiPtSi dans des régions de silicium amorphe à une température par exemple de l'ordre de 400°C.

Du fait de l'amorphisation préalable de certaines régions 123 de la couche semi-conductrice superficielle 12, la frontière des régions 125 d'alliage de métal et de semi-conducteur formée dans ces régions amorphes est mieux définie et la disposition de ces régions 125 d'alliage de métal et de semi-conducteur est mieux contrôlée par rapport à la zone de canal du transistor.

Les régions 123 amorphes dans lesquelles on forme les régions d'alliage de métal et de semi-conducteur sont typiquement formées à l'aide d'une ou plusieurs implantations d'amorphisation.

Dans l'exemple illustré sur la figure 2, la ou les implantations d'amorphisation est ou sont réalisée(s) parallèlement à une normale n à un plan principal du support 100 (i.e. un plan du support parallèle au plan [O ; x ;y] d'un repère orthogonal [O;x;y;z] donné sur la figure 2). On réalise ici de préférence la ou les implantations d'amorphisation après avoir formé des espaceurs isolants 33 de part et d'autre d'un bloc 25 de grille. Cela peut permettre ensuite d'éviter que la siliciuration soit trop proche de la zone de canal et n'empiète sur cette zone.

Dans la mesure où l'on peut ici réaliser des régions de source et de drain réalisées entièrement siliciurées avec des résistances réduites, la ou les implantations d'amorphisation peuvent être ici effectuées sans que l'on ait à contrôler une épaisseur cristalline à préserver dans la couche semi-conductrice superficielle 12.

L'amorphisation peut être avantageusement effectuée sur toute l'épaisseur de la couche semi-conductrice 12 jusqu'à atteindre la couche isolante 11 et être en contact avec cette dernière. Une implantation ionique, par exemple des ions Si+, avec des conditions de dose, d'énergie déterminées par simulation et vérifications expérimentales par imagerie TEM (microscopie électronique en transmission) peut être mise en oeuvre pour rendre amorphe une épaisseur donnée d'une couche de silicium. Des outils de simulations reposant sur une méthode de Monte-Carlo, en particulier de type TRIM (TRIM pour « Transport of Ions in Matter », i.e. Transport d'ions dans la matière, et/ou KMC (pour « kinetic Monte Carlo », i.e. méthode de Monte-Carlo cinétique). Par exemple, une implantation d'ions Ge+ avec une dose (ou fluence) de 5.0 × 10¹⁴ ions*cm⁻² et avec une énergie de 7 keV peut permettre d'obtenir une épaisseur amorphe de l'ordre de 11 nm.

Dans le cas où, le dopage est prévu lors de la même implantation ionique, on peut utiliser des ions d'éléments dopant pour le silicium comme par exemple phosphore ou arsenic pour un dopage de type n ou bore pour un dopage de type p.

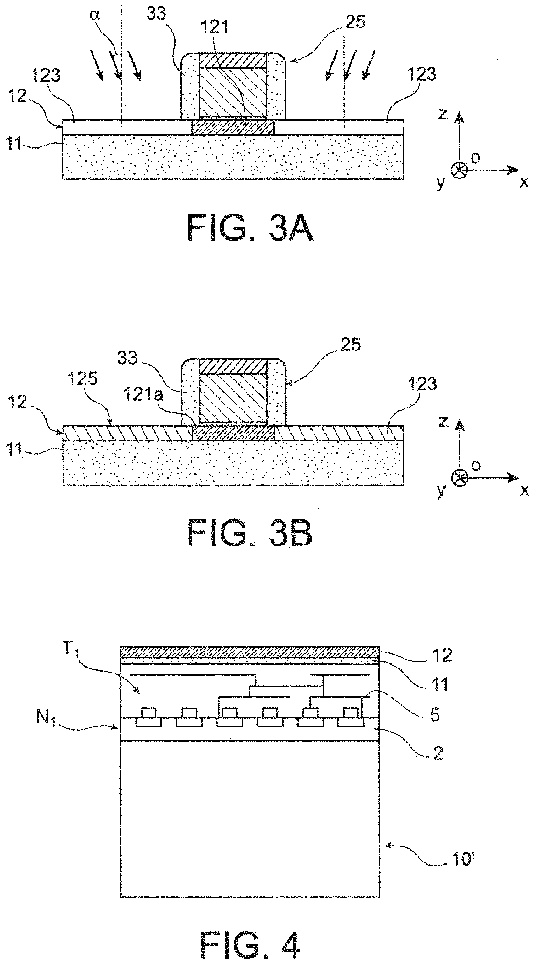

En variante de l'exemple de réalisation décrit précédemment, pour réaliser les régions semi-conductrices amorphes 123, on peut effectuer, comme illustré sur la figure 3A, au moins une implantation d'amorphisation à faisceau incliné, c'est-à-dire avec un angle α du faisceau d'espèces implantées non-nul par rapport à une normale n à un plan principal du support. Dans ce cas, les régions semi-conductrices amorphes 123 peuvent s'étendre en partie en regard des espaceurs isolants 33.

L'implantation d'amorphisation et en particulier l'angle du faisceau peut être prévu de sorte à préserver une zone cristalline 121 en regard des espaceurs 33.

Cela permet ensuite, comme sur la figure 3B, de réaliser des régions 125 d'alliage de métal et de semi-conducteur qui s'étendent partiellement sous les espaceurs 33 tout en préservant une zone 121a non siliciurée en regard des espaceurs.

Selon une autre variante de réalisation, on peut prévoir de mettre en oeuvre un procédé tel que décrit précédemment sur un support différent. En particulier, la structure de départ du procédé peut être telle que dans l'exemple de réalisation particulier de la figure 4. La couche semi-conductrice superficielle 12 et la couche isolante 11 reposent ici sur un support comportant déjà un premier niveau N₁ de composants, par exemple de transistors.

Ainsi, un ou plusieurs transistors T₁ d'un premier niveau N₁ de composants sont dans l'exemple de réalisation illustré formés en partie dans une couche semi-conductrice 2 sous-jacente. Les transistors T₁ du premier niveau N₁ sont ici recouverts d'un ou plusieurs étages d'interconnexions métalliques formés dans une ou plusieurs couches isolantes, typiquement un empilement 5 de couches isolantes, par exemple en SiOz. L'empilement 5 de couches isolantes est doté ou revêtu de la couche isolante 11 de BOX, cette couche isolante 11 étant elle-même revêtue de la couche semi-conductrice superficielle 12.

Le procédé décrit précédemment peut alors être appliqué afin de réaliser un ou plusieurs transistors d'un deuxième niveau et en particulier pour former des régions d'alliage de métal et de semi-conducteur pour les zones de source et drain de transistor(s) du deuxième niveau.

Préalablement à la réalisation des régions 125 d'alliage de métal et de semi-conducteur décrite précédemment, on peut prévoir de réaliser un dopage de zones de la couche semi-conductrice 12 de part et d'autre du bloc 25 de grille et en particulier un dopage de zones d'extension 122 situées de part et d'autre de la grille en regard des espaceurs isolants 33.

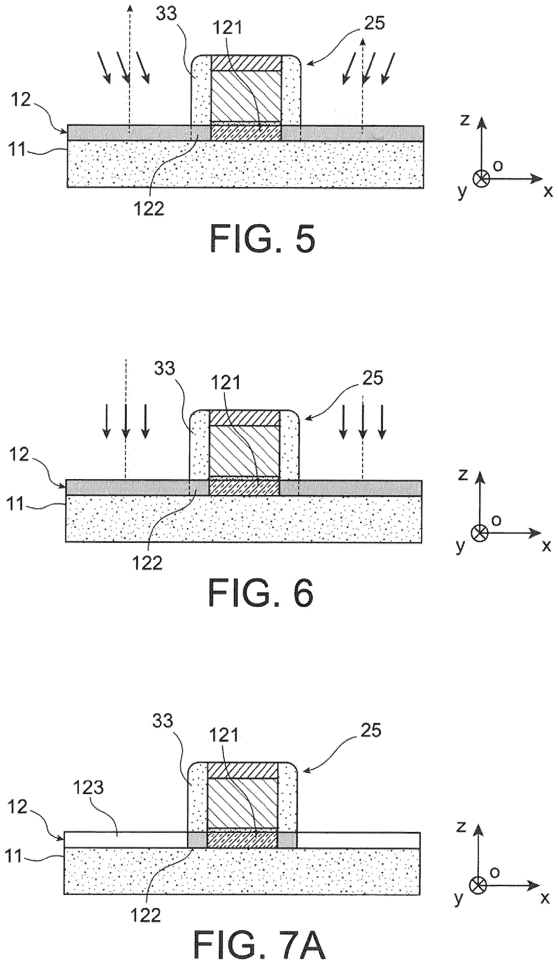

Ainsi, dans l'exemple de réalisation illustré sur la figure 5, on effectue au moins une implantation dopante à l'aide d'un faisceau incliné par rapport à une normale n à un plan principal du support 100 afin de réaliser un dopage sous les espaceurs isolants 33. Les conditions d'implantation dépendent de l'espèce dopante utilisée et de l'inclinaison prévue. Par exemple, pour un dopage n avec du phosphore si l'on fait une implantation avec une inclinaison de 7° une dose critique de l'ordre de 1*10¹⁴at/cm² peut être utilisée. On peut Par exemple réaliser une implantation avec de doses, typiquement inférieures à 2*10¹⁴at/cm² et avantageusement inférieure à 1*10¹⁴at/cm². Une autre option pour ne pas rendre amorphe la couche implantée est de faire une implantation à chaud, typiquement à une température supérieure à 400°C. Dans ce cas, la limite de dose d'implantation est moins contraignante. Cette implantation dopante peut être prévue à faible dose, sans rendre amorphe la couche semi-conductrice 12 superficielle.

Le procédé comprend alors typiquement en outre une étape de recuit d'activation des dopants. Ce recuit peut être un recuit conventionnel par exemple un recuit thermique rapide (communément appelé RTA pour « Rapid Thermal Annealing ») ou bien peut être éventuellement effectué à l'aide d'un laser. Si l'on n'est pas dans le cadre d'une intégration 3D avec la mise en oeuvre d'un dispositif comportant plusieurs couches semi-conductrices superposées, le recuit peut être fait à une température de l'ordre de 1000°C à 1100°C pendant plusieurs secondes. Dans le cadre d'une intégration 3D, où l'on a plusieurs niveaux de composants et/ou de couches semi-conductrices superposé€s, on peut privilégier un recuit laser dit « milliseconde » pour porter la structure aux températures indiquées de 1000°C à 1100°C mais pour une durée de plusieurs dizaines de millisecondes.

On peut ensuite réaliser l'amorphisation et la siliciuration tel que cela a été décrit précédemment.

En variante ou en combinaison de l'exemple de réalisation donné précédemment, on peut réaliser concomitamment par implantation un dopage et une amorphisation de régions de part et d'autre du bloc 25 de grille.

Selon un exemple de réalisation particulier une implantation d'ions P+ avec une dose de 1.5×10¹⁵ ions*cm⁻² selon une énergie de 4 keV peut être effectuée afin de rendre amorphe et doper une couche de silicium d'épaisseur de 12 nm.

Une implantation à l'aide d'un faisceau incliné peut être alors employée. Afin d'éviter de réaliser une amorphisation trop près de la zone de canal du transistor, on peut en variante prévoir d'effectuer une amorphisation et un dopage concomitants par implantation à haute dose, par exemple comprise entre 5×10¹⁴ ions*cm⁻² et 1.0×10¹⁶ ions*cm⁻² ou de l'ordre de 1.5×10¹⁵ ions*cm⁻², avec un faisceau non incliné et parallèle à une normale au plan principal du support.

On effectue alors dans ce cas en outre un dopage de zones d'extension sous les espaceurs 33 par implantation à plus faible dose et éventuellement avec une autre espèce dopante afin d'éviter de réaliser une amorphisation trop proche de la zone de canal.

Dans l'exemple de réalisation illustré sur la figure 6, on effectue le dopage et l'amorphisation concomitantes alors que les zones d'extension 122 sous les espaceurs 33 ont déjà été dopées préalablement.

On peut, par exemple, utiliser les conditions d'implantation telles que données plus haut.

Le ou les étapes de dopage, et en particulier de dopage de zones 122 sont typiquement suivies d'au moins un recuit d'activation de dopants.

Le procédé comprend alors typiquement en outre une étape de recuit d'activation des dopants. Ce recuit peut être un recuit conventionnel par exemple un recuit thermique rapide (ou RTA pour « Rapid Thermal Annealing ») ou bien peut être éventuellement effectué à l'aide d'un laser.

Dans l'exemple de réalisation illustré sur les figures 7A-7B, on réalise tout d'abord
(figure 7A) un dopage des zones d'extension ainsi qu'une amorphisation et un dopage des régions 123 de part et d'autre des espaceurs.

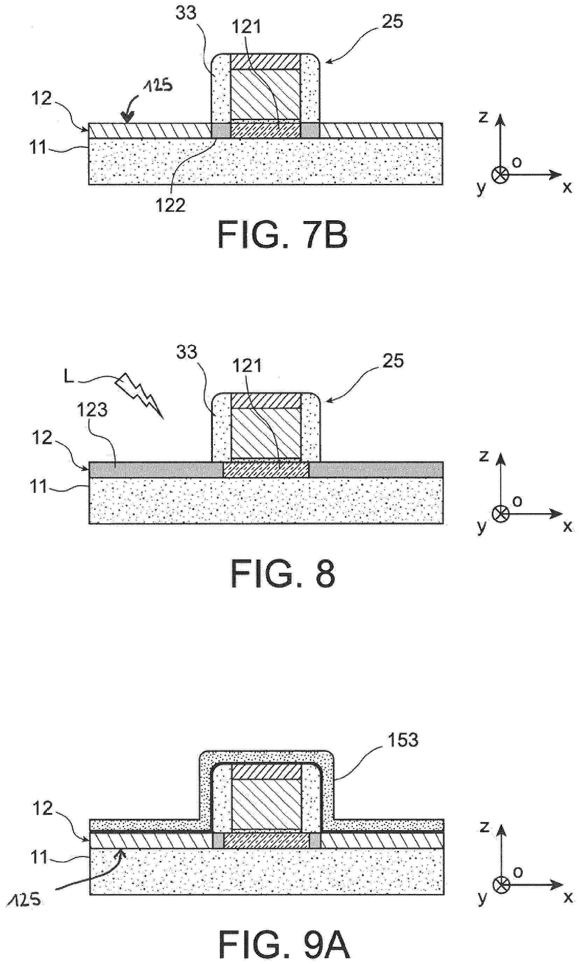

Puis (figure 7B), on forme ensuite les régions 125 d'alliage de métal et de semi-conducteur. Le recuit d'activation de dopants peut être ensuite réalisé.

Dans une variante de réalisation illustrée sur la figure 8, après avoir rendu amorphe des régions semi-conductrices 123 qui ont également été dopées on effectue un recuit d'activation, par exemple à l'aide d'un laser L. Le recuit est alors avantageusement prévu, notamment en termes de durée d'exposition au laser, de sorte à conserver le caractère amorphe A des régions 123 semi-conductrices.

Le recuit peut être réalisé par exemple à l'aide d'un laser de longueur d'onde dans le domaine de l'UV et sous forme d'impulsions de durée typiquement comprise entre 10 et 1000 nanosecondes. L'utilisation d'un laser fonctionnant en régime impulsionnel permet de limiter le budget thermique. La longueur d'onde du laser L, la durée d'impulsion du faisceau laser et de préférence la densité d'énergie du faisceau laser sont choisies de sorte à permettre une activation sans recristalliser les régions 123 rendues amorphe.

Un régime particulier de fusion/resolidification par recuit laser avec une vitesse resolidification suffisante pour obtenir une couche avec une structure de type amorphe peut être en particulier utilisé.

Pour une couche initiale de silicium de l'ordre de 28 à 32 nm d'épaisseur, complètement amorphisée par implantation ionique, un recuit laser avec un laser de longueur d'onde 308 nm et durée d'impulsion entre 100 ns et 200 ns effectué avec une densité d'énergie de 0.7 J/cm² +/-0.05, permet d'obtenir la couche recherchée.

Dans l'exemple de réalisation illustré sur les figures 9A-9^{E}, après avoir réalisé les régions 125 d'alliage de métal et semi-conducteur, on forme des plots de contact 162 sur ces régions 125.

Pour cela, on forme tout d'abord pour cela un masquage isolant 158.

La réalisation du masquage isolant 158 peut, comme sur la figure 9A, comprendre la formation d'une couche isolante 153 ici par dépôt par exemple de nitrure de silicium (SiN).

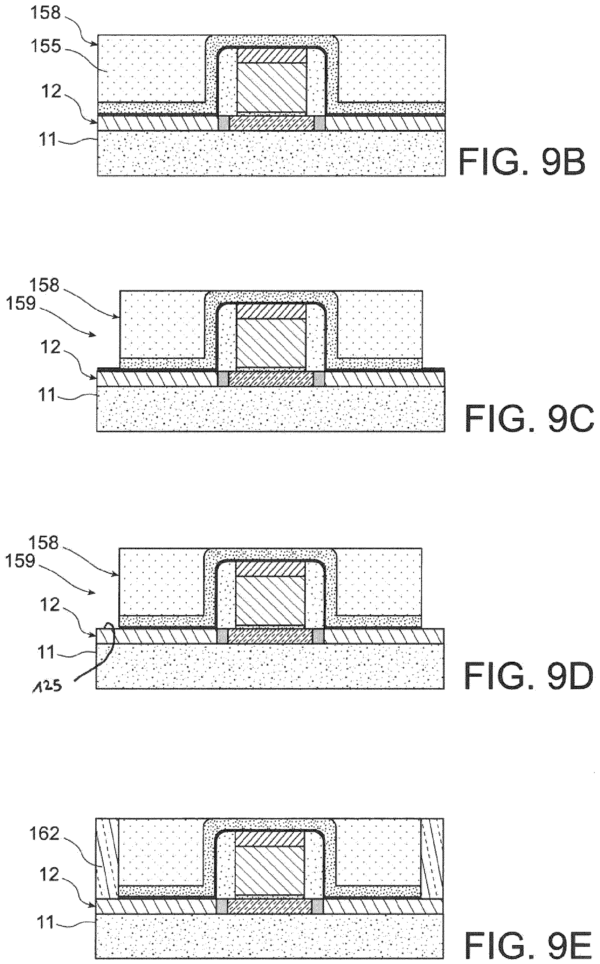

Un dépôt d'oxyde 155 par exemple de type FOX (pour « Field Oxide ») suivi d'une étape de planarisation (figure 9B), typiquement par CMP (« Chemical mechanical planarization » ou « planarisation mécano-chimique ») peuvent être ensuite effectuées.

Puis (figure 9C), on réalise des ouvertures 159 de part et d'autre du bloc 25 de grille, par exemple par gravure jusqu'à atteindre la fine couche isolante 151. On prolonge ensuite (figure 9D) les ouvertures 159 jusqu'à atteindre les régions 125 d'alliage de métal et semi-conducteur.

On dépose ensuite (figure 9^{E}) un matériau conducteur 162 dans les ouvertures, en particulier un métal tel que du W.

Dans l'un ou l'autre des exemples de réalisation décrits précédemment, on forme avantageusement les régions d'alliage de métal et de semi-conducteur directement dans la couche semi-conductrice superficielle 12 sur laquelle repose le bloc de grille et ce, sans qu'une étape d'épitaxie intermédiaire ne soit réalisée pour former des régions de source et de drain surélevées. Le procédé a dans ce cas pour avantage d'être moins coûteux et d'utiliser un budget thermique plus faible.

Bien que nécessitant une étape supplémentaire de croissance par épitaxie, il est en variante toutefois possible de réaliser la siliciuration sélective sur des régions amorphes de blocs semi-conducteurs de source et de drain dits « surélevés », c'est-à-dire situés au-dessus de la face supérieure de la couche semi-conductrice superficielle 12 dans laquelle la zone de canal du transistor est prévue.

Dans l'un ou l'autre exemple de procédés décrits précédemment, les régions d'alliage de métal et de semi-conducteur sont réalisées typiquement à partir d'une couche de silicium. Il est également possible de mettre en oeuvre une réalisation sélectives de régions d'alliage de métal et de semi-conducteur dans des régions rendues amorphes d'un autre matériau semi-conducteur que le silicium, par exemple du Si₁₋ₓGeₓ (avec x> 0).

## Revendications

1. Procédé de fabrication d'au moins une structure de transistor, comprenant, dans cet ordre, les étapes suivantes :
- prévoir sur un support (100) doté d'une couche isolante (11) et d'une couche semi-conductrice superficielle (12) reposant sur la couche isolante (11) : un bloc (25) de grille de transistor sur cette couche semi-conductrice superficielle (12) et des espaceurs isolants (33) de part et d'autre dudit bloc (25) de grille,
- rendre amorphe des régions semi-conductrices (123) de ladite couche semi-conductrice superficielle (12) situées de part et d'autre du bloc (25) de grille, tout en conservant au moins une zone semi-conductrice cristalline (121) de la couche semi-conductrice superficielle (12) sous le bloc (25) de grille,
- former, en particulier de manière sélective par rapport à ladite zone (121) cristalline de la couche semi-conductrice superficielle, des régions d'alliage de métal et de semi-conducteur (125) dans les régions semi-conductrices rendues amorphes de la couche semi-conductrice superficielle (12), le procédé comprenant également, préalablement à l'étape consistant à rendre amorphe ou concomitamment à l'étape consistant à rendre amorphe lesdites régions semi-conductrices (123) :
- le dopage de portions (122, 123) de la couche semi-conductrice superficielle (12) de part et d'autre de ladite zone (121) cristalline,
le procédé comprenant en outre :
après dopage desdites portions (122, 123) de la couche semi-conductrice superficielle et l'étape consistant à rendre amorphe lesdites régions semi-conductrices (123) : au moins un recuit d'activation de dopants prévu de sorte à ne pas recristalliser lesdites régions semi-conductrices (123) rendues amorphes,
ou
après dopage desdites portions (122, 123) de la couche semi-conductrice superficielle et l'étape consistant à former lesdites régions d'alliage de métal et de semi-conducteur (125), au moins un recuit d'activation de dopants.

2. Procédé selon la revendication 1, dans lequel l'étape consistant à rendre amorphe lesdites régions semi-conductrices (123) est effectuée par implantation ionique et de sorte à doper concomitamment lesdites régions semi-conductrices (123) de la couche semi-conductrice superficielle (122).

3. Procédé selon l'une des revendications 1 ou 2, dans lequel, préalablement à l'étape consistant à rendre amorphe lesdites régions semi-conductrices (123), on effectue une implantation de sorte à doper des zones (122) dites d'extension de la couche semi-conductrice superficielle (12), les espaceurs isolants (33) étant agencés en regard desdites zones (122) d'extension.

4. Procédé selon la revendication 3, dans lequel un dopage desdites zones d'extension (122) est effectué par implantation à l'aide d'un faisceau parallèle à une normale (n) à un plan principal du support (100) et préalablement à une étape consistant à former des espaceurs isolants (33) de part et d'autre dudit bloc (25) de grille, l'étape consistant à rendre amorphe les régions semi-conductrices (123) étant réalisée après formation desdits espaceurs isolants (33).

5. Procédé selon la revendication 3, dans lequel un dopage desdites zones d'extension (122) est effectué après formation desdits espaceurs isolants (33) de part et d'autre dudit bloc (25) de grille, par implantation à faisceau incliné par rapport à une normale (n) à un plan principal du support (100).

6. Procédé selon la revendication 5, dans l'étape consistant à rendre amorphe lesdites régions semi-conductrices (123), comprend une implantation à faisceau incliné par rapport à une normale (n) à un plan principal du support (100).

7. Procédé selon l'une des revendications 1 à 6, dans lequel le support (100) est doté d'un ou plusieurs composants d'un premier niveau (N₁) de composants formés dans une couche semi-conductrice (2) sous-jacente.

8. Procédé selon l'une des revendications 1 à 7, comprenant en outre des étapes consistant à :
- former au moins une couche isolante sur les régions d'alliage de métal et de semi-conducteur (125) et la grille,
- réaliser au moins une ouverture dévoilant au moins une région donnée parmi lesdites régions d'alliage de métal et de semi-conducteur (125),
- formation d'un plot conducteur en contact avec ladite région donnée.
